# FASCICULE DE BREVET EUROPEEN

(11) **EP 3 246 953 B1**
(45) Date de publication et mention de la délivrance du brevet: **20.03.2019**
(21) Numéro de dépôt: 17171987.5
(22) Date de dépôt: 19.05.2017
(51) Int. Cl.: H01L 29/66, H01L 29/786, H01L 27/12, H01L 21/8234, H01L 21/8238, H01L 21/84, H01L 21/311, H01L 21/3115, H01L 21/32

(54) **PROCÉDÉ DE RÉALISATION SUR UN MÊME SUBSTRAT DE TRANSISTORS PRÉSENTANT DES CARACTÉRISTIQUES DIFFÉRENTES**
VERFAHREN ZUR HERSTELLUNG VON TRANSISTOREN, DIE UNTERSCHIEDLICHE EIGENSCHAFTEN AUFWEISEN, AUF DEMSELBEN SUBSTRAT
METHOD FOR FORMING, ON A SINGLE SUBSTRATE, TRANSISTORS HAVING DIFFERENT CHARACTERISTICS

(30) Priorité: 20.05.2016 FR 1654556
(43) Date de publication de la demande: 22.11.2017
(73) Titulaire: Commissariat à l'Energie Atomique et aux Energies Alternatives, 75015 Paris (FR)
(72) Inventeur: POSSEME, Nicolas, 38360 SASSENAGE (FR); GRENOUILLET, Laurent, 38640 CLAIX (FR)
(74) Mandataire: Hautier, Nicolas

(56) Documents cités:
- EP-A1- 2 750 170
- EP-A1- 2 876 677
- US-A1- 2004 232 511
- US-A1- 2006 115 988
- US-A1- 2013 149 854
- US-A1- 2014 273 292

## Description

### DOMAINE TECHNIQUE DE L'INVENTION

La présente invention concerne la réalisation sur un même substrat de transistors présentant des caractéristiques différentes, par exemple des oxydes de grille dont les épaisseurs sont différentes. Elle trouvera pour application avantageuse la réalisation de tels transistors sur un substrat de type FDSOI.

### ÉTAT DE LA TECHNIQUE

Pour certains circuits, il est nécessaire de réaliser sur un même substrat élaboré, également désigné tranche ou wafer en anglais, des transistors présentant des caractéristiques différentes, par exemple des épaisseurs différentes d'oxyde de grille.

Les substrats élaborés comprennent généralement un substrat de support surmonté d'une couche d'oxyde et d'une couche semi-conductrice dont l'épaisseur est fine. Ils sont qualifiés de FDSOI (fully depleted silicon on insulator signifiant silicium-sur-isolant totalement déserté) ou PDSOI (partially depleted silicon on insulator signifiant silicium-sur-isolant partiellement déserté) en fonction principalement de l'épaisseur de la couche semi-conductrice.

Les transistors que l'on réalise sur ce type de substrats élaborés présentent un empilement de grille comprenant notamment une grille habituellement en silicium dopé ou en métal, une couche métallique et une couche isolante électriquement dite d'oxyde de grille située entre la couche active et la grille en silicium polycristallin.

Sur un même substrat élaboré, on peut réaliser des transistors d'un premier type présentant une caractéristique différente de celle d'un deuxième type de transistor. Par exemple on peut réaliser, sur un même substrat, des transistors d'un premier type présentant une première épaisseur d'oxyde de grille et des transistors d'un second type présentant une deuxième épaisseur d'oxyde de grille supérieure à la première épaisseur afin de fonctionner à des tensions supérieures.

Les documents US2006/0115988-A1, US2004/232511 et US2013/149854 présentent des plaques qui comportent des transistors dont les propriétés sont différentes.

Afin de limiter la complexité du procédé, de nombreuses étapes sont communes à la réalisation des deux types de transistors dont notamment la réalisation de la couche métallique, la grille en polysilicium, les espaceurs, les sources et drains.

La présente invention a pour objectif de proposer une solution pour intégrer de manière reproductible et simple, sur un même substrat, des transistors présentant des caractéristiques différentes, par exemple des oxydes de grille dont les épaisseurs sont différentes.

### RÉSUMÉ DE L'INVENTION

Pour atteindre cet objectif, selon un mode de réalisation la présente invention prévoit un procédé de réalisation sur un même substrat par exemple de type semi-conducteur sur isolant d'au moins un premier transistor et d'au moins un deuxième transistor, le procédé comprenant au moins les étapes suivantes :
- Réalisation sur un substrat par exemple de type semi-conducteur sur isolant d'au moins un premier motif de grille et d'au moins un deuxième motif de grille ;
- Dépôt sur le premier et le deuxième motif de grille d'au moins une première couche de protection ;
- Masquage du deuxième motif par une couche de masquage ;
- Après l'étape de masquage : modification isotrope de la première couche de protection située sur le premier motif par implantation isotrope d'ions dans la première couche de protection de manière à former des portions modifiées de la première couche ; le deuxième motif étant masqué par la couche de masquage lors de cette modification isotrope;
- Retrait de la couche de masquage;
- Avant l'étape de masquage ou après l'étape de retrait de la couche de masquage: modification anisotrope de la première couche de protection par implantation anisotrope d'ions dans la première couche de protection, l'implantation anisotrope étant effectuée selon une direction privilégiée parallèle à des flancs du deuxième motif de sorte à modifier la première couche de protection au moins sur un sommet du deuxième motif et en dehors des premier et deuxième motifs tout en conservant des portions non-modifiées de la première couche de protection sur les flancs du deuxième motif ;
- Gravure sélective des portions modifiées de la première couche de protection sélectivement aux portions non modifiées de la première couche de protection.

Ainsi, le procédé selon l'invention permet de réaliser sur les flancs du deuxième motif des espaceurs d'épaisseur plus importante que sur les flancs du premier motif.

La présente invention propose ainsi une solution pour intégrer de manière reproductible et simple, sur un même substrat, des transistors présentant des caractéristiques différentes.

Elle offre un avantage particulièrement intéressant pour la réalisation sur un même substrat de transistors dont les empilements de grille présentent des couches isolantes, typiquement des oxydes de grille, dont les épaisseurs sont différentes. En pratique, il a été constaté qu'avec les solutions connues, bien souvent les performances des transistors dont les oxydes de grille sont plus épais se dégradent au fur et à mesure de leur utilisation.

Par conséquent, avec les solutions connues, les performances et la durée de vie des dispositifs comportant ces transistors peuvent représenter une barrière à leur industrialisation.

Dans le cadre de développement de la présente invention, il a été remarqué qu'avec les solutions connues, dans le transistor présentant un empilement de grille dont l'oxyde de grille le plus épais, le champ électrique est le plus élevé à l'interface entre source/drain et espaceurs et non pas au niveau de l'oxyde de grille, comme cela était prévisible.

Ce fort champ électrique peut entraîner le claquage de l'espaceur au fur et à mesure du fonctionnement du transistor.

En prévoyant un espaceur plus épais sur les flancs de la grille du deuxième transistor qui doit supporter des tensions plus élevées, l'invention permet de supprimer ce risque de claquage.

Par ailleurs, l'invention permet de conserver sur les flancs de la grille du premier transistor une épaisseur fine d'espaceur.

L'invention permet ainsi de conserver les performances des transistors dont les oxydes de grille sont les plus fins.

En outre, l'invention présente une complexité limitée par rapport aux solutions classiques dans lesquelles les espaceurs de grille sur les flancs des premier et deuxième transistors sont d'épaisseurs identiques. Notamment le procédé selon l'invention ne nécessite pas de masque additionnel de lithographie. En particulier, de manière avantageuse, le niveau de masque permettant d'introduire la différence d'épaisseur sur l'espaceur est le même que celui utilisé pour induire la différence d'oxyde de grille.

En outre ce procédé ne requiert pas de surgravure additionnelle qui pourrait détériorer la couche active.

Le procédé selon l'invention est ainsi compatible avec les étapes subséquentes qui sont conventionnelles pour finaliser la réalisation des transistors.

Ainsi, l'invention offre une solution efficace, aisément industrialisable et peu onéreuse pour améliorer les performances et la durée de vie des dispositifs présentant des caractéristiques différentes, par exemple des transistors dont les oxydes de grille ont des épaisseurs différentes.

Elle est particulièrement avantageuse pour la réalisation de transistors FDSOI. L'invention s'applique néanmoins notamment aux transistors formés sur des substrats massifs (en anglais « bulk ») ou sur des substrats de type PDSOI.

De manière facultative, l'invention peut en outre présenter au moins l'une quelconque des caractéristiques optionnelles suivantes :
- Selon un mode de réalisation, le premier motif de grille est un premier empilement de grille, et le deuxième motif de grille est un deuxième empilement de grille.

Selon un autre mode de réalisation, le premier motif de grille est un motif sacrificiel et le deuxième motif est un motif sacrificiel. Le procédé comprend, après ladite étape de gravure sélective des portions modifiées, une étape de remplacement des premiers et deuxième motifs sacrificiels par des motifs formant respectivement un premier empilement de grille et un deuxième empilement de grille.
- Selon un autre mode de réalisation, chacun des premier et deuxième empilements de grille comprend au moins une couche isolante, typiquement un oxyde de grille, l'épaisseur de la couche isolante du deuxième empilement étant supérieure à l'épaisseur de la couche isolante du premier empilement.
- Selon un mode de réalisation, l'épaisseur de l'oxyde de grille du premier empilement est comprise entre 0 et 3 nm (10⁻⁹ mètres) et de préférence entre 0 et 1,5 nm.
- Selon un mode de réalisation, l'épaisseur de l'oxyde de grille du deuxième empilement est comprise entre 1,5 et 8 nm, de préférence entre 2 et 6 nm et de préférence entre 2 et 3,5 nm.
- Selon un mode de réalisation le motif de grille est destiné à former une grille pour le transistor. Le motif de grille est alors fonctionnel. Il s'agit alors d'un procédé que l'on peut qualifier de «gate first », c'est-à-dire dans lequel la grille est réalisée au préalable. Selon un autre mode de réalisation, le motif de grille est destiné à être retiré, après avoir formé les espaceurs, pour ensuite être remplacé par un motif fonctionnel de grille. Le motif de grille est alors sacrificiel. Il s'agit alors d'un procédé que l'on peut qualifier de «gate last», c'est-à-dire dans lequel la grille est réalisée dans un second temps.
- Selon un mode de réalisation, le procédé comprend, après l'étape de gravure sélective, une étape de formation d'au moins une couche additionnelle sur les flancs des espaceurs des premier et deuxième motifs.
- Selon un mode de réalisation, l'épaisseur de ladite couche additionnelle est identique sur les flancs des espaceurs des premier et deuxième motifs.
- Selon un mode de réalisation, la modification anisotrope de la première couche de protection par implantation anisotrope d'ions dans la première couche de protection est effectuée avant l'étape de masquage. Alternativement, la modification anisotrope de la première couche de protection par implantation anisotrope d'ions dans la première couche de protection est effectuée après l'étape de retrait de la couche de masquage.
- Selon un mode de réalisation, le substrat comprend une couche active située sous les premier et deuxième motifs de grille et ladite gravure sélective est effectuée de manière à graver les portions modifiées de la première couche de protection sélectivement à la couche active.
- Selon un mode de réalisation, la première couche de protection est en nitrure, de préférence en nitrure de silicium (SiN). Alternativement, la première couche de protection en un matériau dont la constante diélectrique est inférieure à 7 et est de préférence prise parmi les matériaux suivants : un matériau à base de carbone (C), le SiCO, le SiC, le SiCN, le SiOCN, le SiCBN, le SiOCH, le CBN, le BN, le SiCBO et le SiO2.
- Selon un mode de réalisation, la couche de protection est une couche poreuse. Alternativement, la couche de protection est une couche non-poreuse.
- Selon un mode de réalisation, au moins l'une parmi la couche isolante du premier motif et la couche isolante du deuxième motif est une couche d'oxyde de grille.

Par ailleurs, de manière facultative, l'invention peut en outre présenter au moins l'une quelconque des caractéristiques additionnelles suivantes :
Selon un mode de réalisation, la modification isotrope de la première couche de protection par implantation isotrope d'ions dans la première couche de protection est effectuée à l'aide d'un implanteur et en modifiant une direction de bombardement au cours de l'implantation.

Alternativement, la modification isotrope de la première couche de protection est effectuée par implantation isotrope d'ions provenant d'un plasma.
Selon un mode de réalisation, les ions implantés sont des ions hélium ou des ions à base d'hydrogène. Selon un mode de réalisation, au cours de la modification isotrope on maintient une pression supérieure à 100 milli Torr.
Cela permet de rendre l'implantation plus isotrope.

Selon un mode de réalisation, la modification anisotrope de la première couche de protection par implantation anisotrope d'ions dans la première couche de protection est effectuée à l'aide d'un implanteur et en conservant une direction de bombardement sensiblement constante au cours de l'implantation, cette direction étant sensiblement parallèle aux flancs du deuxième motif.
Selon un mode de réalisation, les ions implantés lors de la modification anisotrope sont pris parmi l'une ou plusieurs des espèces suivantes : argon (Ar) et fluore (F).

Alternativement la modification anisotrope de la première couche de protection est effectuée par implantation anisotrope d'ions provenant d'un plasma.
Selon un mode de réalisation, les ions implantés sont des ions hélium ou des ions à base d'hydrogène. Selon un mode de réalisation, au cours de la modification anisotrope on maintient une pression inférieure à 100 milli Torr.
Cela permet d'éviter une déflection des ions qui nuirait à l'anisotropie de l'implantation.

Selon un mode de réalisation, ladite modification anisotrope de la première couche de protection comprend les étapes suivantes :mise en présence de la couche de protection avec un plasma formé à partir d'un mélange gazeux formé d'au moins un premier composant gazeux non carboné dont la dissociation génère les ions légers et un deuxième composant gazeux comprenant au moins une espèce favorisant la dissociation du premier composant pour former les ions légers. Selon un mode de réalisation, le ratio de gaz entre le premier composant et le deuxième composant est supérieur à 1:19 et inférieur à 19 :1.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche de protection 500, sous forme d'ions légers.

De préférence, ledit ratio est compris entre 1 :9 et 9 :1.

Les caractéristiques ci-dessus sont applicables à une modification isotrope si la pression est suffisante pour obtenir une isotropie de la modification.

Par ailleurs, de manière également facultative, l'invention peut en outre présenter au moins l'une quelconque des caractéristiques optionnelles suivantes :
- Selon un mode de réalisation, ladite gravure sélective est une gravure humide à l'aide d'une solution à base d'acide fluorhydrique (HF) et/ou à l'aide d'une solution à base d'acide phosphorique (H₃PO₄).
- Alternativement, ladite gravure sélective est une gravure sèche, de préférence effectuée dans un plasma formé à partir de trifluorure d'azote (NF₃) et d'ammoniac (NH₃). Selon un mode de réalisation, la gravure sèche comprend : une étape de gravure consistant en la formation de sels solides ; une étape de sublimation des espèces solides.
- Alternativement, ladite gravure sélective comprend :
- une gravure sèche réalisée par mise en présence des portions modifiées de la première couche de protection avec un mélange gazeux, de préférence uniquement gazeux, comprenant au moins un premier composant à base d'acide fluorhydrique (HF), l'acide fluorhydrique transformant en résidus non-volatiles à température ambiante la couche diélectrique modifiée,
- uniquement après la gravure sèche: un retrait des résidus non-volatiles à température ambiante par un nettoyage humide ou par un recuit thermique de sublimation.

L'invention sera particulièrement avantageuse pour réaliser un dispositif microélectronique comprenant sur un même substrat de type semi-conducteur sur isolant au moins un premier transistor et au moins un deuxième transistor présentant chacun un motif de grille et des espaceurs situés sur des flancs des motifs, chaque motif de grille comprenant un empilement comprenant au moins une grille et une couche isolante située entre la grille et une couche active dudit substrat. La couche isolante de l'empilement de grille du deuxième transistor présente une épaisseur supérieure à celle du premier transistor. Les espaceurs du deuxième transistor sont plus épais que les espaceurs du premier transistor.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

De manière facultative, le substrat est de type FDSOI, PDSOI ou massif (« bulk »).

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 est une représentation schématique d'un substrat élaboré comprenant des motifs de grille dont les couches diélectrique ont des épaisseurs différentes.
Les FIGURES 2 à 9 illustrent des étapes d'un mode de réalisation du procédé selon l'invention.
La FIGURE 10 résume certaines étapes de deux exemples de procédé selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, les termes « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

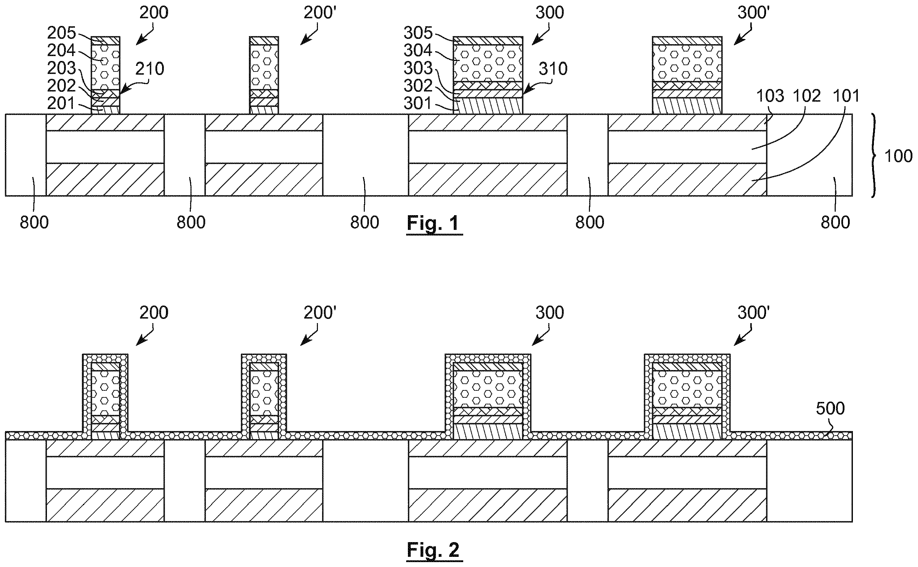

En référence aux figures 1 à 9, un exemple de procédé selon l'invention va maintenant être décrit.

La figure 1 illustre une structure à partir de laquelle les étapes du procédé selon l'invention sont mises en oeuvre. Cette structure comprend des transistors en cours de formation.

Cette structure comprend :
- un substrat élaboré 100 de type semi-conducteur sur isolant (SOI). Sur l'exemple illustré ce substrat élaboré comprend successivement une couche de support 101 ; par exemple en silicium monocristallin, polycristallin ou amorphe; une couche diélectrique 102, habituellement qualifiée d'oxyde enterré (BOX pour Buried Oxide en anglais) et une couche active 103 semi-conductrice destinée à former un canal de conduction d'un transistor. Cette dernière est par exemple en silicium (Si), en germanium (Ge) ou en silicium-germanium (SiGe), de préférence monocristallin.
- des motifs 200, 200', 300, 300' de grille. Dans l'exemple illustré, non limitatif, les motifs 200, 200', 300, 300' de grille forment chacun un empilement de plusieurs couches. Ces motifs 200, 200', 300, 300' sont destinés à être conservés dans les transistors finaux (procédé de type gate first). Selon un mode de réalisation alternatif non illustré, les motifs 200, 200', 300, 300' de grille sont des motifs sacrificiels qui sont destinés à être retirés après réalisation des espaceurs, puis à être remplacés par une autre grille formant de préférence un empilement (procédé de type gate last). L'invention couvre ce mode de réalisation alternatif.

Dans la suite de la description, qui illustre un mode de réalisation de type gate first en référence aux figures, on utilisera aussi bien le terme empilement que motif.
Typiquement, les empilements de grille comprennent chacun au moins une grille 204, 304 habituellement en silicium polycristallin ou en métal et une couche isolante 201, 301 habituellement qualifiée d'oxyde de grille située sous la grille 204, 304 et au travers de laquelle un champ électrique va pouvoir se développer pour créer un canal de conduction sous-jacent entre source et drain quand une tension suffisante est appliquée sur la grille 204, 304.

Sur l'exemple illustré, les transistors formés à partir des motifs 200 et 300 seront de type NFET et les transistors formés à partir des motifs 200' et 300' seront de type PFET. Cet exemple n'est naturellement pas limitatif de l'agencement relatif des transistors de type N et P. Dans la suite de la description et pour des raisons de concision, seuls l'un des deux types de transistors (NFET sur les exemples illustrés) sera décrit et référencé sur les figures. Les étapes décrites en référence aux figures 1 à 9 seront néanmoins applicables aussi bien aux transistors de type N qu'aux transistors de type P.

De manière préférée, chaque empilement de grille 200, 200', 300, 300' comprend également :
- une couche métallique souvent qualifiée de grille métallique 203, 303 et située entre la grille 204, 304 et la couche isolante d'oxyde 201, 301 de grille;
- une couche diélectrique 202, 302, également qualifiée de couche à haute permittivité ou encore appelée « high-k », c'est-à-dire faite d'un matériau à haute permittivité. Cette couche est située entre la couche isolante d'oxyde de grille 201, 301 et la grille métallique 203, 303.
- un masque dur 205, 305 de protection qui sera enlevé ultérieurement pour permettre la reprise de contact sur la grille 204, 304. Ce masque dur 205, 305, qui reste en place après gravure de la grille 204, 304, est typiquement fait d'oxyde de silicium (SiO₂) ou de nitrure de silicium (SiN). Son rôle est de protéger le sommet de la grille 204, 304 de tout dommage lors de la réalisation des étapes suivantes et notamment celles de gravure des espaceurs. On peut trouver une fine couche d'oxyde entre le silicium polycristallin de la grille et le masque dur nitrure.

De préférence, la couche isolante d'oxyde 201, 301 de grille est disposée directement au contact de la couche active 103 formant le canal de conduction et directement au contact de la couche à haute permittivité 202, 302. De préférence, la couche métallique 203, 303 est disposée directement au contact de la couche à haute permittivité 202, 302 et directement au contact de la grille 204, 304.

Selon un autre mode de réalisation la couche métallique 203, 303 et/ou la couche à haute permittivité 202, 302 sont absentes.

Un même substrat élaboré 100 supporte une pluralité de transistors et donc d'empilements de grille. Pour certaines applications, il est nécessaire d'avoir des transistors dont les propriétés sont différentes. Ainsi, certains transistors doivent présenter une couche isolante d'oxyde de grille 301 dont l'épaisseur est plus importante que celle de la couche isolante d'oxyde de grille 201 d'autres transistors.

La figure 1 représente ainsi des empilements de grille 300, 300' dont l'épaisseur de la couche isolante 301 est supérieure à celle de la couche isolante 201 des empilements 200, 200'.

A titre d'exemple non limitatif, on peut ainsi avoir sur un même substrat élaboré 100 :
- des transistors dont la couche isolante d'oxyde de grille présente une épaisseur comprise entre 0 et 1,5 nm. Ces transistors sont connus pour fonctionner à une tension Vdd comprise entre 0,8V et 1V. Ces transistors sont parfois qualifiés de SG ou de G01, sans que cette appellation soit limitative.
   L'épaisseur des espaceurs est mesurée perpendiculairement au plan contenant les flancs 210, 310 des grilles 204, 304, i.e. dans cet exemple, selon une direction parallèle au plan principal dans lequel le substrat 100 s'étend. Cette épaisseur est donc mesurée horizontalement sur les figures 1 à 9.
- des transistors dont l'oxyde de grille présente une épaisseur comprise entre 2 et 5 nm, et plus souvent entre 2 et 3,5 nm. Ces transistors sont connus pour fonctionner à une tension Vdd comprise entre 1,5V et 3,5V. Ainsi la tension de claquage pour ces transistors est plus élevée que la tension maximale appliquée à l'oxyde de grille. Ces transistors sont parfois qualifiés d'EG ou G02, sans que cette appellation soit limitative.
- des transistors dont l'oxyde de grille présente une épaisseur comprise entre 3 et 6 nm sont connus pour fonctionner à une tension Vdd supérieure à 3V. Ainsi la tension de claquage pour ces transistors est plus élevée que la tension maximale appliquée à l'oxyde de grille. Ces transistors sont parfois qualifiés de ZG ou G03, sans que cette appellation soit limitative.

La structure illustrée en figure 1 montre également la présence de tranchée d'isolation 800 traversant toute la couche active 103 pour isoler deux transistors adjacents. Ces tranchées d'isolation 800 s'étendent à travers toute l'épaisseur de la couche active 103 et jusque dans la couche de support 101. Ces tranchées d'isolation sont typiquement réalisées en SiO2.

La figure 2 illustre une étape suivante au cours de laquelle on forme une couche de protection 500 conforme destinée à former des espaceurs sur les flancs 310 des empilement 300, 300'.

Cette première couche de protection 500 est une monocouche sur cet exemple de réalisation. Néanmoins, elle pourrait être formée d'une pluralité de couches.

Typiquement, pour des transistors dont les oxydes de grille 301 ont une épaisseur de l'ordre de 3 à 5 nm, l'épaisseur totale de cette couche de protection 500 présente de préférence une épaisseur comprise entre 3 et 10 nm et de préférence entre 4 et 6 nm.

Par ailleurs, afin de limiter la complexité des procédés et d'en limiter leur coût, il est préférable que les espaceurs de transistors de deux types différents soient réalisés au cours des mêmes étapes.

Cela conduit à ce que, dans les procédés connus, les espaceurs des transistors ayant des oxydes de grille plus épais soient également inférieurs à 9 nm.

Dans le cadre du développement de la présente invention, il a été identifié que cette épaisseur conduit souvent à un claquage au niveau des espaceurs des transistors à oxyde de grille épais, détériorant de ce fait la fiabilité et la durée de vie des dispositifs intégrant ce type de transistors.

Les étapes qui suivent permettent de remédier à ce problème en formant des espaceurs plus épais sur les flancs 310 des empilements 300 dont la couche isolante 301 est plus épaisse, tout en limitant la complexité du procédé.

Cette couche de protection 500 illustrées est par exemple en nitrure, tel qu'en nitrure de silicium (SiN).

Elle peut être en un matériau poreux ou non poreux. Dans le cadre de la présente invention, on désigne par couche poreuse, une couche dans laquelle la présence de vide est supérieure à 5% et de préférence comprise entre 5 et 10%.

Alternativement, la couche 500 peut être faite d'un matériau low-k, i.e. à faible permittivité. Sa permittivité est inférieure à 7 et de préférence inférieure à 4. Elle comprend alors de préférence au moins l'une des espèces suivantes ou une combinaison de ces espèces : silicium (Si), carbone (C), bore (B), azote (N), hydrogène (H). Elle est par exemple formée dans l'un des matériaux suivants : SiCO, SiC, SiCN, SiOCN ou SiCBN. Cette couche low-k est poreuse ou non.

La constante diélectrique de ces couches se mesure par exemple par la méthode classique dite de la goutte de mercure.

La couche de protection 500 est obtenue par un dépôt conforme, c'est-à-dire qu'elle présente une épaisseur constante sur toute la plaque et en particulier sur les flancs 210, 310 et les sommets 220, 320 des empilements 200, 200', 300, 300' de grille ainsi qu'en dehors de ces empilements de grille.

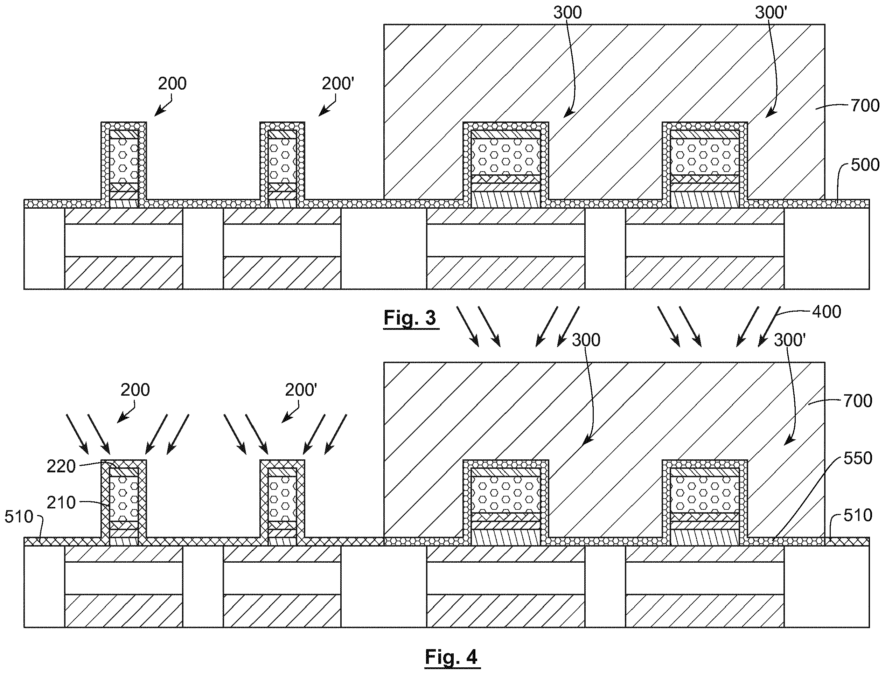

La figure 3 illustre une étape suivante au cours de laquelle on forme une couche de masquage 700 pour recouvrir entièrement le deuxième empilement 300 de grille (et donc également l'empilement 300' sur cette exemple), c'est-à-dire celui présentant une épaisseur de couche isolante (par exemple d'oxyde de grille) 301 supérieure à celle du premier empilement 200. Cette couche de masquage 700 est typiquement une couche à base de carbone, préférentiellement de la résine, déposée pleine plaque, puis ouverte au niveau du premier empilement 200 par l'une des techniques conventionnelles de lithographie.

Dans le cadre de la présente invention, on qualifie de résine un matériau organique ou organo-minéral pouvant être mis en forme par une exposition à un faisceau d'électrons, de photons ou de rayons X ou mécaniquement.

L'étape illustrée en figure 4 vise à modifier de manière isotrope la première couche de protection 500 sur les premiers empilements 200, 200'. A cet effet, cette étape de modification comprend au moins une implantation 400 anisotrope d'ions dans la couche 500, de préférence dans toute l'épaisseur de cette dernière.

Cette implantation 400 d'ions est réalisée de préférence pleine plaque. La première couche 500 recourant les empilements 300, 300' n'est quant à elle pas modifiée car elle est protégée par la couche de masquage 700.

Cette implantation isotrope 400 permet de modifier la couche de protection 500 sans pour autant la pulvériser. Ainsi, il s'agit essentiellement d'une modification chimique, l'ajout d'ions dans cette couche 500 changeant la sélectivité à la gravure de cette couche 500. Ainsi, les portions modifiées 550 se graveront beaucoup plus facilement que les portions non modifiées 510.

L'implantation peut être réalisée :
- dans un implanteur classique, (beamline), c'est-à-dire avec une implantation par faisceau d'ions ;

Un avantage procuré par l'utilisation d'un implanteur est la possibilité de modifier la couche de protection 500 sur les flancs 210 du premier empilement 200 en bombardant selon plusieurs inclinaisons (tilt) la direction d'implantation.

Pour ce type d'implantation, on aura par exemple recours aux espèces suivantes pour modifier la couche de protection 500 : argon (Ar), fluor (F), oxygène (O) ou hydrogène (H). On adaptera l'angle d'inclinaison de l'implantation ainsi que l'énergie des ions en fonction de la densité et de la forme des motifs formés par les empilements 200 de la couche de masquage 700, ainsi qu'en fonction de l'épaisseur de la couche de protection 500.

Typiquement, la dose implantée par faisceau d'ions est supérieure à 1^{E}15 atomes par centimètres carrés (at/cm²).

Ces conditions d'implantation sont par exemple déterminées par simulation en utilisant des outils de simulation de type SRIM (stopping and range of ions matter) ou TRIM (transport simulation of ions in matter). Ces outils de simulation peuvent également être utilisés pour déterminer les conditions d'implantation pour les implantations par plasma qui seront détaillées ci-dessous.
- dans un équipement de gravure plasma. Dans ce cas, on pourra utiliser un réacteur plasma à couplage capacitif (CCP) ou un réacteur plasma à couplage inductif (ICP), ou un plasma par immersion.

L'implantation d'ions par plasma est une solution avantageuse, notamment puisqu'elle permet de contrôler avec précision la profondeur implantée afin :
- d'implanter et donc de modifier toute l'épaisseur de la couche de protection 500 ;
- de ne pas implanter les couches sous-jacentes, en particulier la couche active 103 et la grille 204.

Par ailleurs, l'intérêt du plasma est que l'on a une modification chimique notamment par implantation H, qui rend le retrait de la couche modifiée plus facile.

Selon un exemple de réalisation, cette modification comprend l'implantation d'ions à base d'hydrogène (H, H⁺, H₂⁺, H₃⁺, etc....).

Selon un autre mode de réalisation les ions implantés sont des ions d'hélium (He) ou un mélange d'ions d'hélium et d'hydrogène (H/He).

Ces ions peuvent provenir par exemple des gaz suivants introduits dans le réacteur : H₂, HBr ; NH₃.

Afin d'obtenir une modification isotrope par implantation par plasma on peut jouer sur plusieurs paramètres :
- la pression. De préférence elle est supérieure à 100 milli Torr. Cela permet d'avoir une déflection des ions pour atteindre les flancs 204 des empilements 200, 200'.
- La température. Elle est de préférence inférieure à 100°C ce qui permet de modifier plus efficacement la couche de protection 500. Il a été constaté qu'au-delà de 100°C les ions H implantés désorbent ce qui amoindrit l'effet de modification escompté.
- Les espèces implantées. Les ions à base d'H et He permettent une implantation de la couche de protection 500 sans pulvérisation de cette dernière et sans dépôt à la surface de cette dernière.
- On peut également pulser la tension de polarisation (bias) et/ou la source de manière à accentuer l'effet isotrope.

A l'issue de cette étape d'implantation, toute la couche de protection 500 non recouverte par la couche de masquage 700 est modifiée, de préférence sur toute son épaisseur. Ainsi une couche modifiée 550 est formée, à la fois sur le sommet 220 et les flancs 210 des empilements 200, 200' ainsi qu'entre ces empilements 200, 200'.

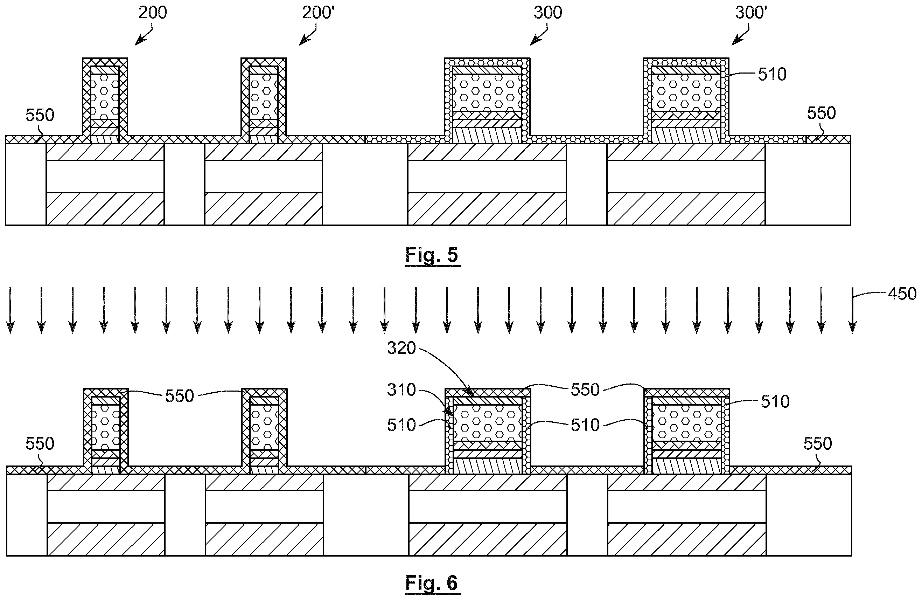

Comme illustré en figure 5, la couche de masquage 700 est ensuite retirée. Naturellement, ce retrait est sélectif du matériau de la première couche modifiée 550 afin de conserver cette dernière sur le premier empilement 200. Lorsque cette couche de masquage 700 est une résine photosensible, elle est par exemple retirée dans un réacteur à couplage capacitif, ou à couplage inductif ou à micro-ondes en utilisant une chimie oxydante (à base d'O₂) ou réductrice (à base d'H₂). Par exemple, on peut injecter un mélange gazeux de N₂ et H₂ dans un réacteur plasma pour la gravure, puis effectuer un nettoyage humide afin de retirer les résidus de résine. Ce nettoyage peut être effectué à l'aide d'une solution SC1 (NH₄OH-H₂O₂).

A ce stade, l'épaisseur initiale de la première couche 500 est conservée dans sa totalité sur les empilements 300, 300'. Elle est modifiée sur tout ou partie de son épaisseur sur les empilements 200, 200'.

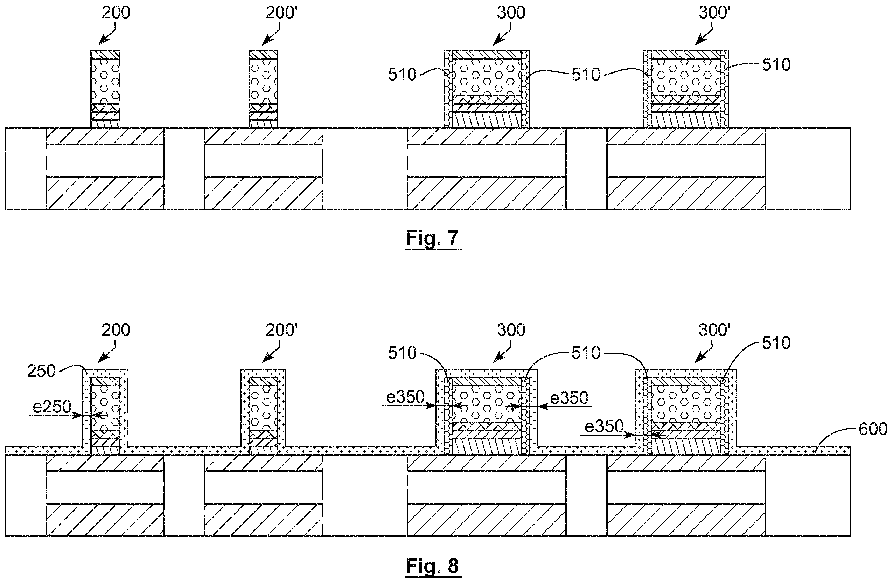

Les figures 6 et 7 visent à modifier et graver de manière anisotrope la première couche de protection 500 sur les empilements 300, 300' afin de supprimer ou réduire l'épaisseur de cette couche 500 sur le sommet 320 des deuxièmes empilements 300, 300' tout en conservant une forte épaisseur de cette couche 500 sur leurs flancs 310 et sans altérer significativement la couche active 103.

La figure 6 illustre une étape de modification anisotrope de la couche de protection 500 par implantation 450 d'ions au sein de cette couche selon une direction privilégiée. Cette direction est parallèle aux flancs 310 des deux empilements 300, 300'. Sur l'exemple illustré, cette direction est perpendiculaire au plan principal dans lequel le substrat 100 s'étend, c'est-à-dire une direction verticale sur cette figure 6.

Comme pour l'implantation 400 isotrope, cette implantation anisotrope permet de modifier la couche de protection 500 sans pour autant la pulvériser. Ainsi, il s'agit essentiellement d'une modification chimique de la couche 500, l'ajout d'ions dans cette couche 500 changeant la sélectivité de la gravure des portions modifiées 550 par rapport aux portions non modifiées 510 de cette couche de protection 500.

Cette modification peut être effectuée par implantation à l'aide d'un implanteur ou à partir d'un plasma. Ces deux modes de réalisation et leurs variantes sont détaillés ci-dessous:

### 1. implantation par implanteurs classiques

Un premier mode de réalisation consiste à implanter des ions à l'aide d'implanteurs habituellement qualifiés de « beamline ». Contrairement à la modification isotrope, l'angle d'implantation reste constant tout au long de l'implantation Cette inclinaison est parallèle aux flancs 310 des empilements 300, 300' recouverts de la couche de protection 500 non modifiée.

Pour ce type d'implantation, la couche de protection 500 est par exemple en nitrure, tel qu'en nitrure de silicium (SiN).

Alternativement, le matériau de la couche de protection est pris parmi : le SiCO, le SiC, le SiCN, le SiOCN, le SiCBN, le SiCBO, le SiOCH, le cBN (cubic boron nitride) et le SiO₂. La couche de protection 500 peut être en un matériau poreux ou non poreux. Elle présente une constante diélectrique de préférence inférieure à 7.

Les espèces implantées peuvent être de l'argon (Ar), du fluor (F), de l'oxygène (O) ou de l'hydrogène (H).. Ces espèces permettent une implantation précise.

A l'étape suivante, les portions modifiées 550 de la couche de protection 500 pourront ainsi être retirées par gravure sèche et de manière sélective vis-à-vis des portions non implantées 510 et de la couche active 103.

### 2. implantation à partir d'un plasma

Un autre mode de réalisation consiste à implanter dans la couche de protection 500 des ions provenant d'un plasma. De préférence, les ions implantés sont des ions légers. On entend par « ions légers » des ions provenant de matériaux dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

De préférence, les ions implantés sont des ions légers tels que des ions d'hélium (He) ou des ions à base d'hydrogène (H, H⁺, H₂⁺, H₃⁺, etc....) dont les numéros atomiques sont respectivement 1 et 2. Plus généralement, les ions légers sont pris parmi les espèces dont le numéro atomique est inférieur ou égal à 10. Une seule ou plusieurs de ces espèces peuvent être implantées.

### a. Premier mode de réalisation par implantation par plasma

La modification de la couche de nitrure par implantation 450 d'ions légers permet d'améliorer considérablement la sélectivité de la couche de protection modifiée 550 vis à vis au matériau semi-conducteur de la couche active 103, typiquement du silicium et vis-à-vis de la couche de protection non modifiée 510.

La gravure qui est ensuite réalisée à l'étape suivante illustrée en figure 7 consomme ainsi la couche de protection modifiée 550 préférentiellement à la couche active 103 de matériau semi-conducteur et à la couche de protection non modifiée 510. Ainsi, le risque de consommation excessive de la couche active 103 superficielle de matériau semi-conducteur est réduit voir supprimé.

De préférence, la modification de la couche de protection 500 conserve tout ou partie de l'épaisseur la couche 500 sur les flancs de la grille 304. Cette épaisseur est conservée, au moins en partie, lors de la gravure sélective. Elle définit alors des espaceurs pour l'empilement de grille 300, 300'.

Ce mode de modification de la couche de protection 500 permet ainsi de déposer une épaisseur plus épaisse que souhaitée au final sur les flancs 310, puis de réduire cette épaisseur en implantant des ions depuis la surface de la couche 500 située sur les flancs 310 et à travers une partie seulement de l'épaisseur de la couche 500. Ainsi on contrôle précisément l'épaisseur de la portion 510 recouvrant la grille 304, tout en évitant d'avoir à effectuer un dépôt très fin de la couche 500 initiale.

Par ailleurs, ce mode de réalisation permet d'obtenir des espaceurs de nitrure ou en matériau low-k dont l'épaisseur est précise tout en réduisant voire en éliminant les problèmes des solutions connues tels que la formation de « pieds » ou la consommation excessive de couche active 103 à la base de la grille.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à quelques nm, ce qui est avantageux pour contrôler précisément l'implantation dans des couches aussi fines que celles déposées pour former les espaceurs.

L'utilisation d'un plasma pour modifier la couche à retirer est donc particulièrement avantageuse puisque l'on souhaite ne pas retirer entièrement la couche de protection 500 sur les flancs ou à retirer une épaisseur fine et soigneusement contrôlée, typiquement comprise entre 1 nm et 5 nm et plus généralement entre 1 nm et 30 nm.

L'étape de modification réalisée à partir d'un plasma modifie la couche de protection 500 de manière continue depuis la surface de la couche de protection 500 et sur une épaisseur comprise entre 1 nm et 30 nm et de préférence entre 1 nm et 10 nm.

Selon un mode de réalisation particulièrement avantageux, l'implantation et le retrait ultérieur de la couche de protection 500 sont réalisées dans un même réacteur plasma. Une modification de la couche 500 à retirer réalisée par une implantation par plasma permet ainsi d'effectuer la modification de la couche et la gravure dans une même chambre ce qui est très avantageux en termes de simplification, de temps et de coût du procédé.

De manière également avantageuse, la modification de la couche de protection 500 par implantation d'ions légers tels que l'hydrogène (H2) ou l'hélium (He) permet également d'améliorer la sélectivité de cette couche de protection modifiée 550 par rapport à l'oxyde du matériau semi-conducteur. Typiquement, la couche de protection modifiée 550 est retirée alors que l'oxyde de grille et les tranchées 800 ne sont pas consommées ou sont moins consommées.

De manière facultative, ce procédé peut en outre présenter au moins l'une quelconque des caractéristiques et étapes ci-dessous :
Avantageusement, l'implantation est effectuée de manière à modifier toute l'épaisseur de la couche de protection 500 en dehors de la couche de protection 500 disposée sur les flancs 310 de la grille 304. Ainsi, la gravure retire toute la couche de protection 500 à l'exception d'une partie au moins de la couche de protection 500 située sur les flancs 310 de la grille 304.

Avantageusement, l'épaisseur de la couche de protection modifiée 550 sur les flancs 310 de la grille 304 est nulle ou est inférieure à l'épaisseur de la couche de protection 500 avant modification par implantation.

De préférence, l'implantation modifie la couche de protection 500 de manière ininterrompue depuis surface.

Selon un mode de réalisation particulier, le procédé comprend une unique étape de modification effectuée de sorte à modifiée la couche de protection 500 dans toute son épaisseur sur toutes les surfaces parallèles au plan d'un substrat 100 sur lequel repose les grilles 304 et à ne pas modifier la couche de protection 500 dans toute son épaisseur sur les surfaces perpendiculaires à ce plan.

Selon un autre mode de réalisation, le procédé comprend plusieurs séquences comprenant chacune une étape de modification et une étape de retrait. Au cours d'au moins l'une des étapes de modification, seule une partie de l'épaisseur de la couche de protection 500 est modifiée. Avantageusement, les séquences sont répétées jusqu'à disparition de la couche de protection 500 sur toutes les surfaces parallèles au plan du substrat 100 sur lequel repose la grille 304. Seules les faces parallèles aux flancs 310 de la grille 304 conservent une épaisseur la couche de protection 500, cette épaisseur n'ayant pas fait l'objet de modification par implantation.

### b. 2^{ème} mode de réalisation par implantation par plasma: Implantation par plasma formé à partir d'un mélange comprenant un composant gazeux favorisant la dissociation d'un autre composant gazeux pour former des ions légers destinés à s'implanter dans la couche de protection 500.

Dans ce mode de réalisation, l'étape de modification de la couche de protection 500 est réalisée par mise en présence de la couche de protection 500 avec un plasma formé à partir d'un mélange gazeux formé d'au moins un premier composant gazeux non carboné dont la dissociation génère les ions légers et un deuxième composant gazeux comprenant au moins une espèce favorisant la dissociation du premier composant pour former les ions légers.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche de protection 500, sous forme d'ions légers. La dose implantée est donc plus élevée sans pour autant avoir besoin d'augmenter la profondeur maximale d'implantation. On évite ainsi d'implanter les couches sous-jacentes telles que la couche active 103. Par ailleurs, on peut retirer une portion de l'épaisseur de la couche de protection 500 sur les flancs 310 tout en contrôlant précisément l'épaisseur que l'on conserve.

Il est donc important de trouver un juste ratio entre la teneur en premier composant et en deuxième composant dans le plasma destiné à modifier la couche de protection 500. Avantageusement, le ratio de gaz entre le premier composant et le deuxième composant est supérieur à 1:19 et inférieur à 19 :1.

Un ratio inférieur, ce qui serait le cas si l'on réduit le débit du premier gaz, aurait pour conséquence de limiter l'efficacité de la modification du film diélectrique.

Un ratio supérieur, ce qui serait le cas si l'on augmente le débit du premier gaz, aurait pour conséquence de limiter l'efficacité du deuxième gaz en termes de dissociation.

De préférence, ledit ratio est compris entre 1 :9 et 9 :1.

Dans la présente demande de brevet un ratio entre deux composants gazeux est un ratio portant sur les débits respectifs d'introduction des composants dans l'enceinte du plasma, typiquement dans le réacteur plasma. Chaque débit se mesure habituellement en sccm. Typiquement un débit se mesure avec un débitmètre associé au réacteur.

Il s'est avéré problématique de cibler une profondeur seuil de sélectivité de la couche de protection 500 qui soit égale à la profondeur d'implantation. De cela, deux problèmes surviennent alors : soit la gravure de la couche de protection modifiée 550 est incomplète nécessitant des étapes répétées de gravure jusqu'à obtenir la profondeur désirée, soit l'implantation opérée dans la couche de protection 500 s'étend au-delà de la couche de protection 500 entrainant de ce fait une altération par implantation de la couche sous-jacente telle que la couche active 103.

Ainsi, ce mode de réalisation repose notamment sur le fait que le deuxième composant formant le plasma est apte à agir comme un gaz de dissociation vis-à-vis du premier composant, avantageusement à base d'hydrogène. En favorisant la dissociation du premier composant, soit de l'hydrogène, on augmente la densité d'ions hydrogène dans la phase gazeuse. Ainsi, pour une même énergie d'implantation, la densité d'hydrogène contenue dans la couche de protection 500 en utilisant le procédé selon ce mode de réalisation est supérieure à celle obtenue à partir d'un plasma ne contenant que de l'hydrogène (H2).

Par ailleurs, et de manière particulièrement avantageuse, la consommation de la couche de protection modifiée 550 par un nettoyage à base d'acide fluorhydrique, par exemple, est proche de la profondeur de l'implantation ionique dans ladite couche de protection modifiée 550. Ainsi, en contrôlant la profondeur d'implantation dans la couche de protection 500, on peut estimer avec une meilleure précision l'épaisseur de la couche de protection modifiée 550 qui sera gravée après implantation.

De manière facultative, le procédé peut en outre présenter au moins l'une quelconque des caractéristiques et étapes ci-dessous.

Selon un mode de réalisation préféré, le premier composant est choisi parmi l'hydrogène (H₂), le nitrure de silicium (SiH₄), le nitrure d'hydrogène (NH₃) ou le bromure d'hydrogène (HBr).

Selon un mode de réalisation préféré, le deuxième composant est choisi parmi l'hélium (He), l'azote (N₂), l'argon (Ar) ou le xénon (Xe).

Avantageusement, le débit du premier composant est compris entre 10 et 1000 sccm (centimètre cube par minute). Avantageusement, le débit du deuxième composant est compris entre 10 et 1000 sccm.

Préférentiellement, l'étape de modification de la couche de protection 500 est réalisée de sorte à fournir une puissance de polarisation ou puissance de source, à une fréquence comprise entre 100 Hz (Hertz) et 5 kHz, avec un cycle opératoire compris entre 10% et 90%.

Pour chacun des modes de réalisation mentionnés précédemment et basés sur une implantation par plasma, les ions légers comprennent des ions à base d'hydrogène (H2) pris parmi : H, H+, H₂+, H₃+. Selon un autre mode de réalisation, les ions légers comprennent des ions à base d'hélium (He) ou à base d'hélium et d'hydrogène.

Pour chacun des modes de réalisation mentionnés précédemment et basés sur une implantation par plasma, la couche de protection 500 est préférentiellement une couche à base de nitrure telle qu'une couche de nitrure de silicium.

Dans un autre mode de réalisation, la couche de protection 500 présente ou comprend un matériau présentant une constante diélectrique inférieure à 7 et de préférence à 4 et de préférence inférieure à 3.1 et de préférence inférieure ou égale à 2, ce qui permet ainsi de réduire capacité parasite pour éventuellement améliorer la performance du transistor. Par exemple, le matériau de la couche de protection est pris parmi : le SiCO, le SiC, le SiCN, le SiOCN, le SiCBN, le SiCBO, le SiOCH, le cBN (cubic boron nitride) et le SiO₂.

Cela permet de réduire la capacité parasite et d'améliorer en conséquence la performance du transistor.

Chacun de ces matériaux peuvent être poreux ou non poreux.

Les caractéristiques et avantages de tous les modes de réalisation indiqués ci-dessus pour effectuer la modification anisotrope de la couche de protection 500, s'appliquent également à la modification isotrope de la couche de protection 500.

De préférence on effectuera la modification isotrope avec le même équipement que la modification anisotrope afin de simplifier le procédé et de réduire les couts.

De préférence, pour ces différents modes de réalisation basés sur une implantation par plasma, on réglera les paramètres suivants afin d'obtenir une implantation anisotrope et sur une profondeur précise correspondant à toute l'épaisseur de la couche de protection 500.

Ces paramètres sont en particulier :
- la pression régnant à l'intérieur de la chambre du réacteur plasma. De préférence, cette pression est inférieure à 100 milli Tor, ceci afin d'éviter une implantation isotrope ;
- la température sera de préférence inférieure à 100°C, afin de modifier efficacement la couche de protection 500.

Pour tous ces modes de réalisation, les conditions d'implantation peuvent être déterminées par simulation à l'aide d'un outil SRIM ou TRIM.

Ainsi à l'issue de cette étape de modification anisotrope,
- la couche de protection 500 est modifiée sur toutes les faces des empilements 200, 200', notamment leurs flancs 210, sur le sommet 320 des empilements 300', 300 et entre les empilements 200, 200', 300, 300'. Certaines surfaces, notamment celles des empilements 200, 200', ont ainsi été modifiées lors de l'implantation isotrope 400 et lors de l'implantation anisotrope 450.
- La couche de protection 500 n'est pas modifiée, ou tout au moins n'est pas modifiée sur toute son épaisseur, au niveau des flancs 310 des empilements 300, 300'.

La figure 7 illustre le résultat de l'étape de gravure sélective des portions modifiées 550 de la couche de protection 500 vis à vis des portions non modifiées 510.

Pour chacun des modes de réalisation mentionnés précédemment et basés sur une implantation par plasma, plusieurs variantes de réalisation pour le retrait sélectif des portions modifiées 550 de la couche de protection 500 sont possibles.

Des chimies de gravure sèches ou humides mentionnées peuvent être utilisées.

Selon un mode de réalisation, l'étape de retrait de la couche de protection modifiée 550 est effectuée par gravure humide sélective audit matériau semiconducteur. Si le matériau semi-conducteur est du silicium, alors l'étape de retrait de la couche de protection modifiée 550 est effectuée par gravure humide sélectivement au silicium (Si) et/ou à l'oxyde de silicium (SiO₂) des tranchées d'isolation 800.

De préférence, la gravure sélective au silicium est obtenue à l'aide d'une solution à base d'acide fluorhydrique (HF) ou à l'aide d'une solution à base d'acide phosphorique (H₃PO₄).

A titre d'exemple avec une solution à base d'acide fluorhydrique (HF), le rapport de vitesse de gravure entre SiN modifié et SiN est de l'ordre de 30; à titre d'exemple, le rapport de vitesse de gravure entre SiN modifié et SiO₂ est de l'ordre de 38.

Cela permet de retirer entièrement la couche de protection modifiée 550 sans consommer la couche de protection non modifiée 510 sur les flancs 310 ; la couche active 103 ; les tranchées 800.

Les performances des transistors sont ainsi préservées.

Le matériau semi-conducteur peut également être du germanium (Ge) ou du silicium-germanium (SiGe).

Selon un autre mode de réalisation, l'étape de retrait est effectuée par gravure sèche sélective audit matériau semiconducteur. De préférence, l'étape de retrait de la couche modifiée de protection 550, typiquement en nitrure de silicium, est effectuée par gravure sèche sélective au silicium (Si) et/ou à l'oxyde de silicium (SiO₂). Selon un mode de réalisation, la gravure sèche est effectuée dans un plasma formé dans une enceinte confinée à partir de trifluorure d'azote (NF₃) et d'ammoniac (NH₃).

Avantageusement, la gravure sèche comprend : une étape de gravure consistant en la formation de sels solides ; une étape de sublimation des espèces solides. Ce mode de réalisation permet d'obtenir une très bonne sélectivité de la gravure du nitrure modifié par rapport au nitrure non modifié et au matériau semi-conducteur non modifié. En particulier, cette sélectivité de la gravure est très supérieure (typiquement un facteur 10 au moins) à celle obtenue avec une solution de HF.

Selon un autre mode de réalisation, l'étape de retrait des portions modifiées 550 de la première couche de protection 500 modifiée vis-à-vis de la première couche de protection 500 non modifiée comprend une gravure sèche réalisée par mise en présence d'un mélange gazeux, de préférence uniquement gazeux, comprenant au moins un premier composant à base d'acide fluorhydrique (HF). L'acide fluorhydrique transforme en résidus non-volatiles, de préférence non-volatiles à température ambiante, les portions modifiées 550 de la première couche de protection 500.

Avantageusement, l'étape de retrait des portions modifiées 550 de la première couche de protection 500 comprend, uniquement après la gravure sèche, un retrait des résidus non-volatiles à température ambiante par un nettoyage humide ou un recuit thermique de sublimation.

De manière particulièrement avantageuse, la présente invention permet une gravure sélective des portions modifiées 550 de la première couche de protection 500 vis-à-vis d'une couche à base d'oxyde de silicium. La plage de variation des paramètres du procédé HF gazeux permettant d'obtenir une sélectivité des portions modifiées 550 de la première couche de protection 500, par exemple à base de nitrure de silicium (SiN) par rapport à la première couche de protection 500 non modifiée, est plus étendue.

Un avantage de la présente invention est que la mise en présence peut être réalisée dans un simple réacteur chimique : une enceinte hermétique dans laquelle les réactifs sont introduits et qui fonctionne soit à température ambiante et pression atmosphérique, soit à température supérieure à l'ambiante et à pression inférieure à la pression atmosphérique. La mise en présence n'est donc avantageusement pas réalisée dans un réacteur plasma dont l'équipement et la gestion est plus complexe qu'un réacteur chimique. Ainsi, le HF gazeux est simple à mettre en oeuvre comparé à un plasma. En effet, un simple réacteur chimique, éventuellement régulé en pression et température, suffit. Dans le cas d'un plasma, il faudrait des générateurs RF et travailler à une pression beaucoup plus basse, donc l'équipement dans ce cas serait nettement plus complexe.

Avantageusement, le recuit thermique et la gravure HF sont effectués lors d'étapes successives et non simultanées. Cela permet d'éviter que la température nécessaire au recuit soit néfaste à l'adsorption du HF à la surface de la plaque, ce qui nuirait au déroulement de la réaction entre HF gazeux et les portions modifiées 550 de la première couche de protection 500, par exemple à base de SiN.

De manière particulièrement avantageuse, ce mode de réalisation permet non seulement un contrôle des dommages pouvant être engendrés suite à une implantation ionique, mais également une amélioration du retrait des portions modifiées 550 de la première couche de protection 500, en proposant un procédé présentant une meilleure sélectivité de gravure entre les portions modifiées 550 de la première couche de protection 500 et la première couche de protection 500 non modifiée d'une part, entre les portions modifiées 550 de la première couche de protection 500 et la couche en oxyde de silicium et entre les portions modifiées 550 de la première couche de protection 500 et la couche en un matériau semi-conducteur, d'autre part. Avantageusement, la sélectivité du procédé de HF gazeux entre la couche de diélectrique modifiée et la couche de matériau semiconducteur est infinie (autrement dit, le HF gazeux ne grave pas le matériau semiconducteur).

Avantageusement, ce mode de réalisation propose une sélectivité infinie des portions modifiées 550 de la première couche de protection 500. Ainsi, la ce mode de réalisation permet un meilleur contrôle des dimensions critiques. Le procédé selon ce mode de réalisation permet en outre une gravure sélective des portions modifiées 550 de la première couche de protection 500 au regard d'autres couches non modifiées par exemple, évitant tout risque de consommer tout ou partie d'une couche à base de nitrure de silicium ou une couche à base d'oxyde de silicium tel que celle formant les tranchées d'isolation 800.

Dans ce mode de réalisation, le procédé est réalisé de façon séquentielle. La gravure, avantageusement « sèche », des portions modifiées 550 de la première couche de protection 500, par exemple de nitrure de silicium (SiN), est effectuée à l'aide d'acide fluorhydrique gazeux pur (pas de co-injection d'alcool). A l'issue de la gravure sèche, des résidus non-volatiles à température ambiante (par exemple, sous forme de sels) sont présents au niveau des portions modifiées 550 de la première couche de protection 500.

On entend par «sel», un composé solide ionique formé d'un anion et d'un cation mais dont la charge électrique globale est neutre.

Selon un premier mode de réalisation, les résidus de gravure non-volatiles peuvent alors être éliminés en effectuant un simple nettoyage humide à l'eau. Selon un autre mode de réalisation préféré mais non limitatif, pour éliminer les résidus non-volatiles à la surface des portions modifiées 550 de la première couche de protection 500, on effectue un recuit après la gravure « sèche » des portions modifiées 550 de la première couche de protection 500. Ce recuit permet de sublimer les résidus non volatiles à température ambiante, typiquement des sels solides Cette méthode peut être utilisée, par exemple, en remplacement d'un nettoyage « humide », par exemple à base d'eau. Avantageusement, cette méthode (HF pur gazeux suivi d'un recuit) alternative propose un procédé entièrement « sec » (qui ne contient pas d'étapes en phase liquide), qui peut être intéressant pour éliminer les problèmes connus causés lors de gravures « humides » réalisées pour la formation de motifs, par exemple.

Selon un mode de réalisation avantageux, on réalise une étape de pré-recuit avant la gravure sèche à base d'acide fluorhydrique gazeux. Cela permet d'éliminer l'humidité naturellement adsorbée sur des substrats et évite ainsi d'introduire de l'eau, qui est un accepteur de protons, à l'intérieur de la chambre de traitement du graveur ; ladite chambre comprenant de l'acide fluorhydrique (HF). Ainsi l'étape de pré-recuit permet d'augmenter davantage la sélectivité entre une couche de nitrure de silicium modifiée (SiN) et une couche d'oxyde de silicium (SiO2).

De manière particulièrement avantageuse, aucune gravure d'une couche d'oxyde de silicium (SiO2) ne peut se produire puisque le procédé de gravure d'une couche à base d'oxyde de silicium ne fonctionne qu'avec la présence simultanée de l'acide fluorhydrique et de groupes accepteurs de protons (tels que l'alcool, l'eau). C'est donc par l'absence de mise en présence simultanée de l'acide fluorhydrique et de groupes accepteurs de protons, qu'est obtenue une grande sélectivité entre une couche de nitrure de silicium (SiN) modifiée et une couche d'oxyde de silicium (SiO2). Ce processus séquentiel montre également une grande sélectivité entre une couche de nitrure de silicium (SiN) non modifiée et une couche de nitrure de silicium modifiée.

De manière particulièrement avantageuse, le procédé séquentiel selon ce mode de réalisation offre une meilleure sélectivité de gravure de la couche de protection modifiée vis-à-vis de du silicium (Si) et du silicium-germanium (SiGe). Ce procédé présente également une meilleure sélectivité de gravure vis-à-vis de l'oxyde de silicium (SiO2) formant par exemple le masque dur ou les tranchées d'isolation 800 ou du nitrure de silicium (SiN) non-modifié, notamment grâce à l'absence de groupes accepteurs de protons en utilisant un procédé à base d'acide fluorhydrique gazeux pur. D'autres solutions connues pour enlever une couche de nitrure de silicium SiN modifiée telles que l'acide fluorhydrique (HF) en phase liquide ou l'acide phosphorique (H3PO4) ne permettent pas une telle sélectivité envers, respectivement, l'oxyde de silicium (SiO2) ou le nitrure de silicium (SiN) non modifié.

Avantageusement, les paramètres de l'étape de retrait des portions modifiées 550 de la première couche de protection 500, notamment le ratio de gaz entre le premier composant et le deuxième composant utilisé lors de la gravure sèche, sont prévus de sorte à ce que les portions modifiées 550 de la première couche de protection 500 puisse être gravée de manière sélective vis-à-vis de la couche en un matériau semi-conducteur et vis-à-vis de la première couche de protection 500 non modifiée et, avantageusement, vis-à-vis de la couche en oxyde de silicium. Il est donc important de trouver un juste ratio entre la teneur en premier composant et en deuxième composant lors de la gravure sèche destinée à retirer les portions modifiées 550 de la première couche de protection 500. Avantageusement, le ratio de gaz entre le premier composant (par exemple, HF gazeux) et le deuxième composant (par exemple, N2 pur) est compris entre 1 :25 et 1 :1.

Un ratio inférieur, ce qui serait le cas si l'on réduit le débit du premier composant, aurait pour conséquence de limiter l'efficacité de la gravure des portions modifiées 550 de la première couche de protection 500. Un ratio supérieur, ce qui serait le cas si l'on augmente le débit du premier composant, aurait pour conséquence de limiter la sélectivité vis-à-vis de la couche en nitrure de silicium non-modifiée et vis-à-vis de la couche en oxyde de silicium. Dans la présente demande de brevet, on entend par ratio entre deux composants gazeux, un ratio portant sur les débits respectifs d'introduction des composants dans l'enceinte du réacteur chimique (lors de l'utilisation de HF gazeux). Chaque débit se mesure habituellement en centimètre cube par minute (sccm). Typiquement un débit se mesure avec un débitmètre associé à chaque flux de gaz entrant dans le réacteur.

Avantageusement, la gravure sèche consomme les portions modifiées 550 de la première couche de protection 500 préférentiellement à la couche en un matériau semi-conducteur et à la première couche de protection 500 non modifiée. Ainsi, le risque de consommation excessive de la couche superficielle de matériau semi-conducteur est réduit, voire supprimé.

L'étape illustrée en figure 8 comprend le dépôt d'une deuxième couche de protection 600 conforme sur tous les empilements 200, 200', 300, 300'. Cette deuxième couche de protection 600, faite d'un diélectrique, peut être monocouche ou non. Elle a pour vocation de former un espaceur 610 sur chacun des flancs 210 des empilements 200, 200' et des flancs 310 des empilements 300, 300'.

Ainsi, à ce stade, sur chacun des flancs 210 des empilements 200, 200', une espaceur 250 est formé et présente une épaisseur « e 250 » référencée en figure 8. Cette épaisseur correspond à l'épaisseur de la deuxième couche de protection 600. Sur chacun des flancs 310 des empilements 300, 300', est formé un espaceur 350 qui présentera une épaisseur « e 350 » correspondant à la somme des épaisseurs des portions non modifiées 510 de la première couche de protection 500 et à l'épaisseur de la deuxième couche de protection 600.

De préférence, la deuxième couche de protection 600 est un matériau pris parmi ceux mentionnés précédemment pour la couche de protection 500. Elle peut être poreuse ou non-poreuse. Elle peut être dans un matériau identique ou différent de celui de la couche de protection 500.

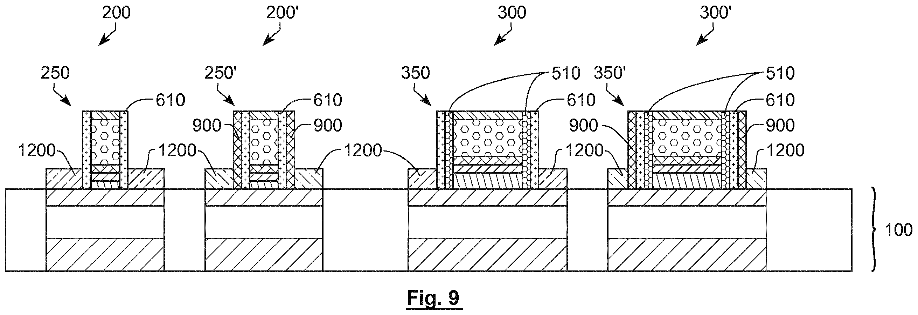

Une étape optionnelle non illustrée peut consister à former des espaceurs 900 sur les flancs des empilements 200' et 300', c'est-à-dire du type PFET dans cet exemple. Ces espaceurs 900 sont illustrés en figure 9. Ils sont réalisés comme les espaceurs 610, par dépôt d'une troisième couche de protection conforme, puis retrait de cette couche en dehors des flancs de ces empilements 200', 300'.

Dans ce cas :
- les espaceurs 250 des transistors NFET, dont la couche isolante 201 d'oxyde de grille est fine, sont formés par une portion 610 au moins de la deuxième couche de protection 600 ;
- les espaceurs 250' des transistors PFET, dont la couche isolante 201 d'oxyde de grille est fine, sont formés par une portion 610 au moins de la deuxième couche de protection 600 et une portion 900 de la troisième couche de protection;
- les espaceurs 350 des transistors NFET, dont la couche isolante 301 d'oxyde de grille est épaisse, sont formés par une portion 610 au moins de la deuxième couche de protection 600 et par une portion 510 au moins de la première couche de protection 500.
- les espaceurs 350' des transistors PFET, dont la couche isolante 301 d'oxyde de grille est épaisse, sont formés par une portion 610 au moins de la deuxième couche de protection 600 et par une portion 510 au moins de la première couche de protection 500 et par une portion 900 au moins de la troisième couche de protection 900.

On peut ensuite mettre en oeuvre d'autres étapes pour finaliser la réalisation des transistors.

Parmi ces étapes classiques, on pourra par exemple prévoir le retrait de la deuxième couche 600 sur les sommets 220, 320 des empilements 200, 200', 300, 300' et entre ces empilements pour ne conserver des portions 510, 610 de ces couches 500 et 600 uniquement sur les flancs 210, 310 des empilements 200, 200', 300, 300'.

Une autre étape concerne la croissance des source et drain 1200 par épitaxie à partir de la couche active 103 comme illustré en figure 9.

Au vu de la description qui précède, il apparaît clairement que le procédé selon l'invention permet d'améliorer la durée de vie des dispositifs intégrant sur une même puce des transistors dont les épaisseurs de grille sont différentes, sans pour autant augmenter de manière significative la complexité du procédé de fabrication.

L'invention n'est pas limitée aux modes de réalisation précédemment décrits et s'étend à tous les modes de réalisation couverts par les revendications.

Par exemple on pourra inverser l'ordre de certaines étapes. Notamment, l'étape d'implantation anisotrope 450 de la première couche de protection 500 peut être effectuée avant l'étape de masquage des deuxièmes empilements 300, 300'. Selon ce mode de réalisation alternatif, une fois l'étape d'implantation anisotrope 450 de la première couche de protection 500 effectuée, on réalise ensuite l'étape de masquage des deuxièmes empilements 300, 300', puis l'étape de modification isotrope 400.

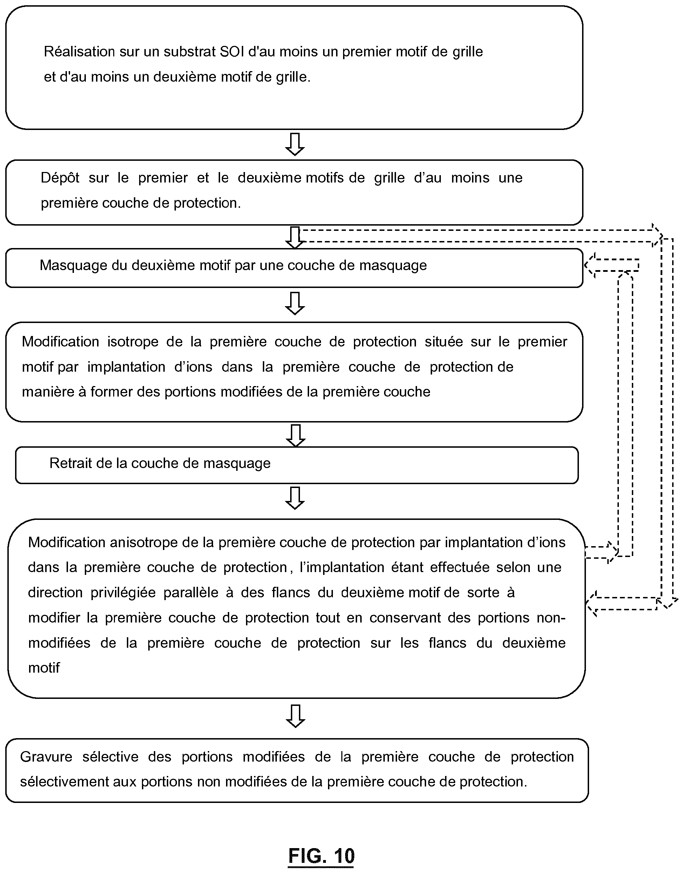

Ce mode de réalisation alternatif est illustré en figure 10 par les flèches en pointillés.

Les détails, exemples et avantages des étapes du mode de réalisation décrit en détail en référence aux figures 1 à 9 s'appliquent à ce mode de réalisation alternatif dans lequel l'étape de gravure anisotrope 450 de la première couche de protection 500 est effectuée avant masquage du deuxième empilement 300.

L'invention couvre également le cas où l'on grave les portions modifiées 550 de la première couche de protection vis-à-vis des portions non modifiée 510 de la première couche de protection 500 à l'issue de chaque étape de modification 400 et 450.

Néanmoins, les modes de réalisation décrits ci-dessus avec une seule étape de gravure sélective effectuée à l'issue des deux implantations (isotrope 400 et anisotrope 450) sont avantageuses en termes de coût et de simplification du procédé.

Bien que l'invention soit particulièrement avantageuse pour réaliser sur un même substrat des transistors dont les empilements de grille présentent des couches isolantes (typiquement une couche d'oxyde de grille) d'épaisseurs différentes, cela n'est pas limitatif. En effet l'invention s'applique également à la réalisation sur un même substrat de transistors dont les empilements de grille présentent des couches isolantes d'épaisseurs identiques.

Par ailleurs, dans les modes de réalisation illustrés, l'empilement de grille est réalisé préalablement aux étapes de l'invention. Ces figures illustrent ainsi un procédé de type gate first.

Selon un autre mode de réalisation couvert par l'invention, l'empilement fonctionnel de grille est réalisé postérieurement aux étapes de l'invention. L'empilement de grille sur lequel est déposée la première couche de protection forme donc un motif sacrificiel qui sera retiré, une fois les espaceurs réalisés. Ce mode de réalisation alternatif est ainsi un procédé de type gate last.

### REFERENCES

- 100: Substrat élaboré
- 101: Couche porteuse
- 102: Couche diélectrique
- 103: Couche active

- 200: Premier empilement/Motif
- 201: Couche isolante du premier empilement
- 202: Couche à haute permittivité du premier empilement
- 203: Grille métallique du premier empilement
- 204: Grille du premier empilement
- 205: Masque dur du premier empilement
- 210: Flanc du premier empilement
- 220: Sommet du premier empilement
- 250: Espaceur du premier empilement

- 300: Deuxième empilement/Motif
- 301: Couche isolante du deuxième empilement
- 302: Couche à haute permittivité du deuxième empilement
- 303: Grille métallique du deuxième empilement
- 304: Grille du deuxième empilement
- 305: Masque dur du deuxième empilement
- 306: Cavité
- 310: Flanc du deuxième empilement
- 320: Sommet du deuxième empilement
- 350: Espaceur du deuxième empilement

- 400: Implantation isotrope
- 450: Implantation anisotrope

- 500: Première couche de protection
- 510: Portion non modifiée de la première couche de protection
- 550: Portion modifiée de la première couche de protection

- 600: Deuxième couche de protection
- 610: Portion de deuxième couche de protection

- 700: Couche de masquage
- 800: Tranchée d'isolation
- 900: Troisième couche de protection

- 1200: Source/Drain

## Revendications

1. Procédé de réalisation sur un même substrat (100) d'au moins un premier transistor et d'au moins un deuxième transistor, **caractérisé en ce que** le procédé comprend au moins les étapes suivantes :
- Réalisation sur un substrat (100) d'au moins un premier motif (200, 200') de grille et d'au moins un deuxième motif (300, 300') de grille ;
- Dépôt sur le premier et le deuxième motif (200, 200', 300, 300') de grille d'au moins une première couche de protection (500) ;
- Masquage du deuxième motif (300, 300') de grille par une couche de masquage (700) ;
- Après l'étape de masquage : modification isotrope de la première couche de protection (600) située sur le premier motif de grille (200, 200') par implantation isotrope (400) d'ions dans la première couche de protection (600) de manière à former des portions modifiées (550) de la première couche (500) ;
- Retrait de la couche de masquage (700);
- Avant l'étape de masquage ou après l'étape de retrait de la couche de masquage (700): modification anisotrope de la première couche de protection (500) par implantation anisotrope (450) d'ions dans la première couche de protection (500), l'implantation anisotrope (450) étant effectuée selon une direction privilégiée parallèle à des flancs (310) du deuxième motif de grille (300, 300') de sorte à modifier la première couche de protection (500) au moins sur un sommet (320) du deuxième motif de grille (300, 300') et en dehors des premier et deuxième motif de grilles (200, 200', 300, 300') tout en conservant des portions non-modifiées (510) de la première couche de protection (500) sur les flancs (310) du deuxième motif de grille (300, 300') ;
- Gravure sélective des portions modifiées (550) de la première couche de protection (500) sélectivement aux portions non modifiées (510) de la première couche de protection (500).

2. Procédé selon la revendication précédente dans lequel le premier motif de grille (200, 200') est un premier empilement de grille et dans lequel le deuxième motif (300, 300') de grille est un deuxième empilement de grille, et dans lequel chacun des premier et deuxième empilements de grille comprend au moins une couche isolante (201, 301), typiquement un oxyde de grille.

3. Procédé selon la revendication 1 dans lequel le premier motif de grille (200, 200') est un motif sacrificiel, dans lequel le deuxième motif (300, 300') est un motif sacrificiel, le procédé comprenant, après ladite étape de gravure sélective des portions modifiées (550), une étape de remplacement des premiers et deuxième motifs (200, 200', 300, 300') sacrificiels par des motifs formant respectivement un premier empilement de grille et un deuxième empilement de grille, et dans lequel chacun des premier et deuxième empilements de grille comprend au moins une couche isolante (201, 301), typiquement un oxyde de grille.

4. Procédé selon l'une quelconque des deux revendications précédentes dans lequel l'épaisseur de la couche isolante (301) du deuxième empilement est supérieure à l'épaisseur de la couche isolante (201) du premier empilement.

5. Procédé selon l'une quelconque des revendications précédentes comprenant, après l'étape de gravure sélective, une étape de formation d'au moins une couche additionnelle (610) sur les flancs (210, 310) des espaceurs (250, 350) des premier et deuxième motifs (200, 200', 300, 300').

6. Procédé selon l'une quelconque des revendications précédentes :
- dans lequel la modification anisotrope de la première couche de protection (500) par implantation anisotrope (450) d'ions dans la première couche de protection (500) est effectuée avant l'étape de masquage, ou
- dans lequel la modification anisotrope de la première couche de protection (500) par implantation anisotrope (450) d'ions dans la première couche de protection (500) est effectuée après l'étape de retrait de la couche de masquage (700).

7. Procédé selon l'une quelconque des revendications précédentes dans lequel le substrat (100) comprend une couche active (103) située sous les premier et deuxième motifs (200, 200', 300, 300') de grille et ladite gravure sélective est effectuée de manière à graver les portions modifiées (550) de la première couche de protection (500) sélectivement à la couche active (103).

8. Procédé selon l'une quelconque des revendications précédentes dans lequel la première couche de protection (500) est en nitrure, de préférence en nitrure de silicium (SiN) ou dans lequel :la première couche de protection (500) en un matériau dont la constante diélectrique est inférieure à 7 et est de préférence prise parmi les matériaux suivants : un matériau à base de carbone (C), le SiCO, le SiC, le SiCN, le SiOCN, le SiCBN, le SiOCH, le CBN, le BN, le SiCBO et le SiO2.

9. Procédé selon l'une quelconque des revendications précédentes :
- dans lequel la modification isotrope de la première couche de protection (500) par implantation isotrope (400) d'ions dans la première couche de protection (500) est effectuée à l'aide d'un implanteur et en modifiant une direction de bombardement au cours de l'implantation ou
- dans lequel la modification isotrope de la première couche de protection (500) est effectuée par implantation isotrope (400) d'ions provenant d'un plasma et dans lequel de préférence les ions implantés sont des ions hélium ou des ions à base d'hydrogène, dans lequel de préférence au cours de la modification isotrope on maintient une pression supérieure à 100 milli Torr.

10. Procédé selon l'une quelconque des revendications précédentes dans lequel la modification anisotrope de la première couche de protection (500) par implantation anisotrope (450) d'ions dans la première couche de protection (500) est effectuée à l'aide d'un implanteur et en conservant une direction de bombardement sensiblement constante au cours de l'implantation, cette direction étant sensiblement parallèle aux flancs (310) du deuxième motif (300, 300').

11. Procédé selon l'une quelconque des revendications 1 à 9 dans lequel la modification anisotrope de la première couche de protection (500) est effectuée par implantation anisotrope (450) d'ions provenant d'un plasma, dans lequel les ions implantés sont de préférence des ions hélium ou des ions à base d'hydrogène, et dans lequel au cours de la modification anisotrope on maintient une pression de préférence inférieure à 100 milli Torr.

12. Procédé selon la revendication précédente dans lequel ladite modification anisotrope de la première couche de protection (500) comprend les étapes suivantes :mise en présence de la couche de protection (500) avec un plasma formé à partir d'un mélange gazeux formé d'au moins un premier composant gazeux non carboné dont la dissociation génère les ions légers et un deuxième composant gazeux comprenant au moins une espèce favorisant la dissociation du premier composant pour former les ions légers et dans lequel le ratio de gaz entre le premier composant et le deuxième composant est supérieur à 1:19 et inférieur à 19 :1.

13. Procédé selon l'une quelconque des revendications précédentes dans lequel ladite gravure sélective est une gravure humide à l'aide d'une solution à base d'acide fluorhydrique (HF) ou à l'aide d'une solution à base d'acide phosphorique (H₃PO₄).

14. Procédé selon l'une quelconque des revendications 1 à 12 dans lequel ladite gravure sélective est une gravure sèche, de préférence effectuée dans un plasma formé à partir de trifluorure d'azote (NF₃) et d'ammoniac (NH₃) et dans lequel la gravure sèche comprend : une étape de gravure consistant en la formation de sels solides ; une étape de sublimation des espèces solides.

15. Procédé selon l'une quelconque des revendications 1 à 12 dans lequel ladite gravure sélective comprend
- une gravure sèche réalisée par mise en présence des portions modifiées (550) de la première couche de protection (500) avec un mélange gazeux, de préférence uniquement gazeux, comprenant au moins un premier composant à base d'acide fluorhydrique (HF), l'acide fluorhydrique transformant en résidus non-volatiles à température ambiante la couche diélectrique modifiée,
- uniquement après la gravure sèche: un retrait des résidus non-volatiles à température ambiante par un nettoyage humide ou par un recuit thermique de sublimation.

## Patentansprüche

1. Verfahren zum Herstellen zumindest eines ersten Transistors und zumindest eines zweiten Transistors auf demselben Substrat (100), **dadurch gekennzeichnet, dass** das Verfahren zumindest die nachstehenden Schritte umfasst:
- Herstellen zumindest eines ersten Gate-Musters (200, 200') und zumindest eines zweiten Gate-Musters (300, 300') auf einem Substrat (100);
- Abscheiden zumindest einer ersten Schutzschicht (500) auf dem ersten und dem zweiten Gate-Muster (200, 200', 300, 300');
- Maskieren des zweiten Gate-Musters (300, 300') mit einer Maskierungsschicht (700);
- nach dem Schritt des Maskierens isotropes Modifizieren der auf dem ersten Gate-Muster (200, 200') befindlichen ersten Schutzschicht (600) durch isotrope Ionenimplantation (400) in der ersten Schutzschicht (600), derart, dass modifizierte Abschnitte (550) der ersten Schicht (500) gebildet werden;
- Entfernen der Maskierungsschicht (700);
- vor dem Schritt des Maskierens oder nach dem Schritt des Entfernens der Maskierungsschicht (700) anisotropes Modifizieren der ersten Schutzschicht (500) durch anisotrope Ionenimplantation (450) in der ersten Schutzschicht (500), wobei die anisotrope Ionenimplantation (450) in einer Vorzugsrichtung parallel zu den Flanken (310) des zweiten Gate-Musters (300, 300') erfolgt, derart, dass die erste Schutzschicht (500) zumindest an einer Oberseite (320) des zweiten Gate-Musters (300, 300') und außerhalb des ersten und zweiten Gate-Musters (200, 200', 300, 300') modifiziert wird und dabei nicht modifizierte Abschnitte (510) der ersten Schutzschicht (500) an den Flanken (310) des zweiten Gate-Musters (300, 300') erhalten bleiben;
- selektives Ätzen der modifizierten Abschnitte (550) der ersten Schutzschicht (500) selektiv an den nicht modifizierten Abschnitten (510) der ersten Schutzschicht (500).

2. Verfahren nach dem vorangehenden Anspruch, wobei das erste Gate-Muster (200, 200') ein erster Gate-Stapel ist und wobei das zweite Gate-Muster (300, 300') ein zweiter Gate-Stapel ist, und wobei jeder aus erstem und zweitem Gate-Stapel zumindest eine Isolierschicht (201, 301), typischerweise ein Gateoxid, enthält.

3. Verfahren nach Anspruch 1, wobei das erste Gate-Muster (200, 200) ein Opfermuster ist und das zweite Muster (300, 300') ein Opfermuster ist, wobei das Verfahren nach dem Schritt des selektiven Ätzens der modifizierten Abschnitte (550) einen Schritt des Ersetzens des ersten und zweiten Opfermusters (200, 200', 300, 300') durch Muster umfasst, die jeweils einen ersten Gate-Stapel bzw. einen zweiten Gate-Stapel bilden, und wobei jeder aus erstem und zweitem Gate-Stapel zumindest eine Isolierschicht (201, 301), typischerweise ein Gateoxid, enthält.

4. Verfahren nach einem der beiden vorangehenden Ansprüche, wobei die Dicke der Isolierschicht (301) des zweiten Stapels höher ist als die Dicke der Isolierschicht (201) des ersten Stapels.

5. Verfahren nach einem der vorangehenden Ansprüche, umfassend nach dem Schritt des selektiven Ätzens einen Schritt des Bildens zumindest einer Zusatzschicht (610) an den Flanken (210, 310) von Spacern (250, 350) des ersten und des zweiten Musters (200, 200', 300, 300').

6. Verfahren nach einem der vorangehenden Ansprüche, wobei:
- die anisotrope Modifizierung der ersten Schutzschicht (500) durch anisotrope Ionenimplantation (450) in der ersten Schutzschicht (500) vor dem Schritt des Maskierens erfolgt, oder
- die anisotrope Modifizierung der ersten Schutzschicht (500) durch anisotrope Ionenimplantation (450) in der ersten Schutzschicht (500) nach dem Schritt des Entfernens der Maskierungsschicht (700) erfolgt.

7. Verfahren nach einem der vorangehenden Ansprüche, wobei das Substrat (100) eine Wirkschicht (103) enthält, die unter dem ersten und dem zweiten Gate-Muster (200, 200', 300, 300') liegt, und das selektive Ätzen so erfolgt, dass die modifizierten Abschnitte (550) der ersten Schutzschicht (500) selektiv an der Wirkschicht (103) geätzt werden.

8. Verfahren nach einem der vorangehenden Ansprüche, wobei die erste Schutzschicht (500) aus Nitrid, vorzugsweise aus Siliciumnitrid (SiN) besteht, oder wobei die erste Schutzschicht (500) aus einem Material besteht, dessen Dielektrizitätskonstante unter 7 liegt und vorzugsweise ausgewählt ist aus den nachstehenden Materialien: ein Material auf Basis von Kohlenstoff (C), SiCO, SiC, SiCN, SiOCN, SiCBN, SiOCH, CBN, BN, SiCBO und SiO2.

9. Verfahren nach einem der vorangehenden Ansprüche, wobei:
- die isotrope Modifizierung der ersten Schutzschicht (500) durch isotrope Ionenimplantation (400) in der ersten Schutzschicht (500) mittels einer Implantiervorrichtung und durch Ändern einer Bombardierungsrichtung im Laufe der Implantation erfolgt, oder
- die isotrope Modifizierung der ersten Schutzschicht (500) durch isotrope Ionenimplantation (400) von Ionen erfolgt, die aus einem Plasma stammen, und wobei vorzugsweise die implantierten Ionen Heliumionen oder Ionen auf Basis von Wasserstoff sind, wobei vorzugsweise im Laufe der isotropen Modifizierung ein Druck höher als 100 milli Torr aufrechterhalten wird.

10. Verfahren nach einem der vorangehenden Ansprüche, wobei die anisotrope Modifizierung der ersten Schutzschicht (500) durch anisotrope Ionenimplantation (450) in der ersten Schutzschicht (500) mittels einer Implantiervorrichtung und unter Beibehaltung einer im Wesentlichen konstanten Bombardierungsrichtung im Laufe der Implantation erfolgt, wobei diese Richtung im Wesentlichen parallel zu den Flanken (310) des zweiten Musters (300, 300') verläuft.

11. Verfahren nach einem der Ansprüche 1 bis 9, wobei die anisotrope Modifizierung der ersten Schutzschicht (500) durch anisotrope Ionenimplantation (450) von Ionen erfolgt, die aus einem Plasma stammen, wobei die implantierten Ionen vorzugsweise Heliumionen oder Ionen auf Basis von Wasserstoff sind, wobei im Laufe der anisotropen Modifizierung ein Druck vorzugsweise geringer als 100 milli Torr aufrechterhalten wird.

12. Verfahren nach dem vorangehenden Anspruch, wobei die anisotrope Modifizierung der ersten Schutzschicht (500) die nachstehenden Schritte umfasst: Inkontaktbringen der ersten Schutzschicht (500) mit einem Plasma, das aus einem gasförmigen Gemisch gebildet ist, das aus zumindest einer nicht kohlenstoffhaltigen gasförmigen Komponente gebildet ist, deren Dissoziation leichte Ionen erzeugt, sowie aus einer gasförmigen Komponente, die zumindest eine Spezies enthält, die die Dissoziation der ersten Komponente begünstigt, um leichte Ionen zu bilden, und wobei das Gasverhältnis zwischen der ersten Komponente und der zweiten Komponente über 1:19 und unter 19:1 liegt.

13. Verfahren nach einem der vorangehenden Ansprüche, wobei das selektive Ätzen ein Nassätzen mit Hilfe einer Lösung auf Basis von Fluorwasserstoffsäure (HF) oder mit Hilfe einer Lösung auf Phosphorsäure (H₃PO₄) ist.

14. Verfahren nach einem der Ansprüche 1 bis 12, wobei das selektive Ätzen ein Trockenätzen ist, das vorzugsweise in einem Plasma erfolgt, das ausgehend von Stickstofftrifluorid (NF₃) und Ammoniak (NH₃) gebildet ist, und wobei das Trockenätzen umfasst: einen Schritt des Ätzens, der in der Bildung von festen Salzen besteht; einen Schritt der Sublimation von Feststoffspezies.

15. Verfahren nach einem der Ansprüche 1 bis 12, wobei das selektive Ätzen umfasst:
- Trockenätzen, das durch Inkontaktbringen der modifizierten Abschnitte (550) der ersten Schutzschicht (500) mit einem gasförmigen, vorzugsweise ausschließlich gasförmigen, Gemisch, erfolgt, das zumindest eine erste Komponente auf Basis von Fluorwasserstoffsäure (HF) enthält, wobei die Fluorwasserstoffsäure die modifizierte dielektrische Schicht bei Raumtemperatur zu nichtflüchtigen Rückständen umwandelt,
- ausschließlich nach dem Trockenätzen: Entfernen der nichtflüchtigen Rückstände bei Raumtemperatur durch Nassreinigen oder durch eine Wärmebehandlung unter Sublimation.

## Claims

1. Method for producing, on one same substrate (100), at least one first transistor and at least one second transistor, **characterised in that** the method comprises at least the following steps:
- Production on a substrate (100) of at least one first grid pattern (200, 200') and at least one second grid pattern (300, 300');
- Deposition on the first and second grid pattern (200, 200', 300, 300') of at least one first protective layer (500);
- Masking of the second grid pattern (300, 300') by a masking layer (700);
- After the masking step: isotropic modification of the first protective layer (600) situated on the first grid pattern (200, 200') by isotropic implantation (400) of ions in the first protective layer (600) so as to form modified portions (550) of the first layer (500);
- Removal of the masking layer (700);
- Before the masking step or after the step of removing the masking layer (700): anisotropic modification of the first protective layer (500) by anisotropic implantation (450) of ions in the first protective layer (500), the anisotropic implantation (450) being done along a favoured direction parallel to the flanks (310) of the second grid pattern (300, 300') so as to modify the first protective layer (500) at least on a peak (320) of the second grid pattern (300, 300') and outside of the first and second grid patterns (200, 200', 300, 300') while conserving non-modified portions (510) of the first protective layer (500) on the flanks (310) of the second grid pattern (300, 300');
- Selective etching of modified portions (550) of the first protective layer (500) selectively at the non-modified portions (510) of the first protective layer (500).

2. Method according to the preceding claim, wherein the first grid pattern (200, 200') is a first grid stack and wherein the second grid pattern (300, 300') is a second grid stack, and wherein each of the first and second grid stacks comprises at least one isolating layer (201, 301), typically a grid oxide.

3. Method according to claim 1, wherein the first grid pattern (200, 200') is a sacrificial pattern, wherein the second pattern (300, 300') is a sacrificial pattern, the method comprising, after said step of selectively etching modified portions (550), a step of replacing the first and second sacrificial patterns (200, 200', 300, 300') with patterns respectively forming a first grid stack and a second grid stack, and wherein each of the first and second grid stacks comprises at least one isolating layer (201, 301), typically a grid oxide.

4. Method according to any one of the two preceding claims, wherein the thickness of the isolating layer (301) of the second stack is greater than the thickness of the isolating layer (201) of the first stack.

5. Method according to any one of the preceding claims comprising, after the selective etching step, a step of forming at least one additional layer (610) on the flanks (210, 210) of the spacers (250, 350) of the first and second patterns (200, 200', 300, 300').

6. Method according to any one of the preceding claims:
- wherein the anisotropic modification of the first protective layer (500) by anisotropic implantation (450) of ions in the first protective layer (500) is done before the masking step, or
- wherein the anisotropic modification of the first protective layer (500) by anisotropic implantation (450) of ions in the first protective layer (500) is done after the step of removing the masking layer (700).

7. Method according to any one of the preceding claims, wherein the substrate (100) comprises an active layer (103) situated under the first and second grid patterns (200, 200', 300, 300') and said selective etching is done so as to etch the modified portions (550) of the first protective layer (500) selectively at the active layer (103).

8. Method according to any one of the preceding claims, wherein the first protective layer (500) is made of nitride, preferably silicon nitride (SiN) or wherein the first protective layer (500) made of a material of which the dielectric constant is less than 7 and is preferably taken from among the following materials: a material with a base of carbon (C), SiCO, SiC, SiCN, SiOCN, SiCBN, SiOCH, CBN, BN, SiCBO and SiO₂.

9. Method according to any one of the preceding claims:
- wherein the isotropic modification of the first protective layer (500) by isotropic implantation (400) of ions in the first protective layer (500) is done using an implanter and by modifying a bombardment direction during the implantation, or
- wherein the isotropic modification of the first protective layer (500) is done by isotropic implantation (400) of ions coming from a plasma and wherein preferably the implanted ions are helium ions or hydrogen-based ions, wherein preferably during the isotropic modification, a pressure greater than 100 milli Torr is maintained.

10. Method according to any one of the preceding claims, wherein the anisotropic modification of the first protective layer (500) by anisotropic implantation (450) of ions in the first protective layer (500) is done using an implanter and by conserving a substantially constant bombardment direction during the implantation, this direction being substantially parallel to the flanks (310) of the second pattern (300, 300').

11. Method according to any one of claims 1 to 9, wherein the anisotropic modification of the first protective layer (500) is done by anisotropic implantation (450) of ions coming from a plasma, wherein the implanted ions are preferably helium ions or hydrogen-based ions, and wherein during the anisotropic modification, a pressure preferably less than 100 milli Torr is maintained.

12. Method according to the preceding claim, wherein said anisotropic modification of the first protective layer (500) comprises the following steps, brought from the protective layer (500) with a plasma formed from a gaseous mixture formed from at least one first non-carbonated gaseous component of which the separation generates light ions and a second gaseous component comprising at least one species favouring the separation of the first component to form light ions and wherein the gas ratio between the first component and the second component is greater than 1:19 and less than 19:1.

13. Method according to any one of the preceding claims, wherein said selective etching is a wet etching using a hydrofluoric acid (HF)-based solution or using a phosphoric acid-based solution (H₃PO₄).

14. Method according to any one of claims 1 to 12, wherein said selective etching is a dry etching, preferably done in a plasma formed from nitrogen trifluoride (NF₃) and ammoniac (NH₃) and wherein the dry etching comprises: an etching step consisting of the formation of solid salts; a step of subliming solid species.

15. Method according to any one of claims 1 to 12, where said selective etching comprises:
- a dry etching done by bringing modified portions (550) of the first protective layer (500) with a gaseous mixture, preferably only gaseous, comprising at least one first hydrofluoric (HF) acid-based component, the hydrofluoric acid transforming the modified dielectric layer into non-volatile residues at ambient temperature,
- only after the dry etching: a removal of non-volatile residues at ambient temperature by a wet cleaning or by a thermal sublimation annealing.
